Europäisches Patentamt

European Patent Office

Office européen des brevets

(11) Publication number: **0 366 405**

**A2**

# EUROPEAN PATENT APPLICATION

(21) Application number: **89310936.3**

(51) Int. Cl.⁵ **H01R 9/07**

(22) Date of filing: **24.10.89**

(30) Priority: **25.10.88 US 262387**

(43) Date of publication of application:
**02.05.90 Bulletin 90/18**

(84) Designated Contracting States:
**DE FR GB IT**

(71) Applicant: **Hewlett-Packard Company**
**3000 Hanover Street**
**Palo Alto California 94304(US)**

(72) Inventor: **Asakawa, Stuart**
**9919 Azuaga Street No. E-107**
**San Diego California 92129(US)**
Inventor: **Firl, Gerold**
**14141 Ezra Lane**
**Poway California 92064(US)**
Inventor: **Duffy, John**
**1 Midridge Circle**
**Londonderry NH 03053(US)**

(74) Representative: **Colgan, Stephen James et al**
**CARPMAELS & RANSFORD 43 Bloomsbury**
**Square**
**London WC1A 2RA(GB)**

(54) Viabond tabcircuit electrical connector.

(57) An electrical connector is formed of electrically conductive traces supported on an insulating plastic support. Vias are provided through the support so that the traces are supported over the via openings in at least two positions. Most typically, the vias have parallel opposing edges, and the traces are supported across the via opening from the opposing edges. This connector design containing vias permits two types of improvements in use. First, the doubly supported traces are resistant to misalignment, and are more readily bonded to bonding points on a component, as compared with singly supported, cantilevered traces. Second, the connector can be more readily bent over angularities on the surface of a component when a via is placed in registry with the angularity, because the bending of the traces is not constrained and the overall stiffness of the connector is reduced so that less force is required to bend the connector over the angularity.

FIG.6

## VIABOND TABCIRCUIT ELECTRICAL CONNECTOR

### BACKGROUND OF THE INVENTION

This invention relates to connectors for making electrical connections to electrical components, and, more particularly, to a TABcircuit electrical connector having electrical traces supported on an electrically insulating substrate.

One of the continuing trends in the electronics and electromechanical apparatus industries has been to reduce the size of many components and types of apparatus. There are many reasons to strive for reduced size, but generally miniaturization increases the speed of operation of electronic devices and reduces the cost of components and apparatus.

As the size of the components is reduced, the difficulty in providing external electrical interconnections to the components becomes greater. Assuming that the number of required external connections for any particular component remains approximately constant even as the size is reduced, the space around the periphery of the device that is available to make the connections becomes smaller. Thus, for example, a 10 fold reduction in component external dimension also reduces the available length of periphery available for bonding by 10 fold.

Since the linear length and space required to make external connections typically does not scale downwardly, the reductions in component size have prompted many approaches to attain improved connectability. In one, a flexible connector material called a TAB (for Tape Automated Bonding) flexible circuit material has been introduced. A TABcircuit electrical connector material includes a flexible insulating support layer, typically made of a polyimide plastic such as Kapton (a registered trademark of Dupont Corporation) or Upilex. Traces of electrically conducting material are formed on the surface of the support layer.

The electrical connector and traces are made in various configurations adapted for use with particular electrical components. The flexible circuit material is made with openings therethrough that register with the electrical connection points on the components which are to be provided with an external connection. The traces are cantilevered from the edges of the openings to lie directly above the connection points on the component. Bonding of each trace to its corresponding connection point is made by pressing the trace downwardly to contact the trace metal to the connection point, with a tool (called a thermode or bonding tip) that can apply any combination of heat, pressure, and ultrasonic energy, to the bonding region, thereby accomplishing a weldment between the trace and the bonding point. The bonding points on the component are typically raised slightly above their general plane to provide a well defined contact point and to avoid electrical shorts due to contacts at other locations. The bonding of the traces is usually accomplished by robotic devices. This approach of flexible TABcircuit bonding is well suited for manufacturing large numbers of identically configured circuits, because the bonding material is manufactured in long strips or rolls and the bonding operation is automated.

The TABcircuit bonding approach is widely used to make various types of devices. For example, US Patents 3,689,991 and 4,649,415, which are incorporated by reference, describe the use of flexible circuit bonding to semiconductor components. US Patent 4,635,073, which is incorporated by reference, describes the use of flexible circuit bonding for thermal ink jet printer print heads.

Although its use has greatly increased the efficiency of many manufacturing operations, the flexible circuit bonding approach has drawbacks in practice. The trace fingers that extend over the bonding locations on the electrical component are quite small, and can be easily misaligned either during manufacture and handling, or during the bonding operation. Misalignment of even one of the trace fingers in a typical bonding operation results in unacceptable operation and rejection of the final product. In some applications, such as establishing connections to thermal ink jet printer print heads, the flexible bonding circuits must be bent to fit the angular contours of the components, and the bending operation can damage the traces. As a result, the rejection rates for devices bonded with flexible bonding circuits has in some cases been unacceptably high.

Accordingly, there is a need for an improved approach to establishing electrical connections to components. Ideally, such an approach would offer the advantages inherent in the use of flexible circuits, while avoiding the problems just discussed. The present invention fulfills this need, and further provides related advantages.

### SUMMARY OF THE INVENTION

The present invention provides an electrical connector having the advantages of conventional flexible electrical connector of the TABcircuit type. It greatly reduces the likelihood of bending and consequent misalignment of the portion of the traces that contact the connection pads or locations on the component to be electrically contacted. Also, it is not necessary to raise the connection locations to avoid the possibility of short circuits. The same approach that permits the improvement in making the electrical contacts also allows the flexible electrical connector to be more readily shaped to angularities, further reducing the chances of failures. The flexible electrical connector of the invention is not more costly to produce than conventional flexible connector material.

In accordance with the invention, an electrical connector comprises an electrically insulating support having a via therethrough; and an electrically conductive trace on a surface of the support, the trace bridging across the via opening so as to be supported over the via opening by contact with the support along the edges of the via in at least two locations.

In the conventional flexible TAB circuit electrical connector material, the conductive traces are supported fully along their lengths by the insulating support, except at the end to be bonded to the component. At that end, the metallic traces extend outwardly from the insulating support in a cantilevered fashion. When the flexible connector is placed into registry overlying the component, it is intended that the traces will be in proper position for bonding directly above the bonding locations on the component. Unfortunately, the traces are so fragile that they may unintentionally be bent to the side a sufficient distance to miss proper registry over the bonding locations. A single such missed contact results in the final device being unusable.

The present invention provides a properly positioned via or window through the insulating support, with the metallic trace material being supported from the edges of the via, over the via opening, in at least two places. In the most typical application, the traces and vias are disposed so that the traces extend directly across the via opening from one side to the other. With this configuration, the trace is solidly supported at both ends, rather than at only one end.

Also in accordance with the invention, an electrical connector for use in establishing electrical connection to a circuit component having at least one electrical connection point on a surface thereof comprises an electrically insulating support having a via therethrough in registry with the electrical connection point of the circuit device, when the support is overlaid onto the surface of the circuit component; and an electrically conductive trace on a surface of the support, the trace bridging across the via opening so as to be supported over the via opening by contact with the support along the edges of the via in at least two locations.

In accordance with this bonding aspect of the invention, a process for providing electrical connection for a circuit component having at least one electrical connection point on a surface thereof comprises the steps of providing an electrical connector having an electrically insulating support having a via therethrough in registry with the electrical connection point of the circuit component, when the support is overlaid onto the surface of the circuit component, and an electrically conductive trace on a surface of the support, the trace bridging across the via opening so as to be supported over the via opening by contact with the support along the edges of the via in at least two locations; placing the connector to overlie the circuit component so that the via opening and a portion of the trace supported over the via opening are in registry with the electrical connection point on the surface of the circuit component; and bonding the trace to the electrical connection point.

The presence of the vias in the flexible electric connector material also permits the material to be bent more readily to conform to angular irregularities, or angularities. In accordance with this aspect of the invention, a process for conforming an electrical connector to an angular irregularity in the surface of an electrical component comprises the steps of providing an electrical connector having an electrically insulating support having a via therethrough, and an electrically conductive trace on a surface of the support, the trace bridging across the via opening so as to be supported over the via opening by contact with the support along the edges of the via in at least two locations; placing the connector to overlie the circuit component so that the via opening and a portion of the trace are supported over the angular irregularity; and bending the electrical connector so that the traces are bent over the angular irregularity in the region overlying the via opening, whereby the traces are not in contact with support material in the region in which they are bent. In this manner, the stiffness of the electrical connector is reduced, so that it may be bent without imposing unduly high bending stresses and constraint stresses on the traces. The traces may be on the upper or lower surface of the support, relative to the upper surface of the electrical component. Thus, even though the traces do not contact the support in the region of the angular irregularity, they may contact the circuit component if the traces are on the bottom of the support, adjacent the upper surface of the circuit component.

The invention extends to an electrical device prepared using the preceding principles. In accordance with this aspect of the invention, an electrically connected device comprises a circuit component having at least one electrical connection point on an upper surface thereof; and an electrical connector that provides an external electrical connection to the electrical connection point of the circuit component, the connector having an electrically insulating support having a via therethrough in registry with the electrical connection point of the circuit component, when the support is overlaid onto the upper surface of the circuit component, and an electrically conductive trace on a surface of the support, the trace bridging across the via opening so as to be supported over the via opening by contact with the support along the edges of the via in at least two locations.

The electrical conductor material of the invention, having vias therethrough, is manufactured by the same techniques as used for conventional TABcircuit conductor material. The vias are placed so as to aid in the bonding or bending processes, as may be required for each application. The locating of the vias poses no particular constraint in the manufacturing of the conductor material, because it is made in a custom manner for the particular application in any event. Other features and advantages of the invention will be apparent from the following more detailed description of the invention and the preferred embodiments, taken in conjunction with the accompanying drawings, which illustrate, by way of example, the principles of the invention.

## BRIEF DESCRIPTION OF THE DRAWINGS

Figure 1 is a perspective view of a thermal ink jet print head assembly;

Figure 2 is an exploded perspective view of the thermal ink jet print head assembly of Figure 1;

Figure 3 is an enlarged side sectional view of the flexible connector in relation to a portion of the print head assembly, prior to bonding the traces to the bonding locations;

Figure 4 is an enlarged side sectional view of the flexible connector in relation to a portion of the print head assembly, after bonding the traces to the bonding locations;

Figure 5 is a side elevational view of an integrated circuit device utilizing a flexible connector; and

Figure 6 is an enlarged perspective view of a portion of Figure 1.

## DETAILED DESCRIPTION OF THE INVENTION AND THE PREFERRED EMBODIMENTS

The presently preferred application of the present invention is in conjunction with a thermal ink jet printhead assembly 10, used to eject microdroplets of ink toward a print medium in a precisely controlled array. Such a printhead assembly is disclosed in US Patent 4.635,073. The present invention is also useful in bonding to other electrical components, such as integrated circuits.

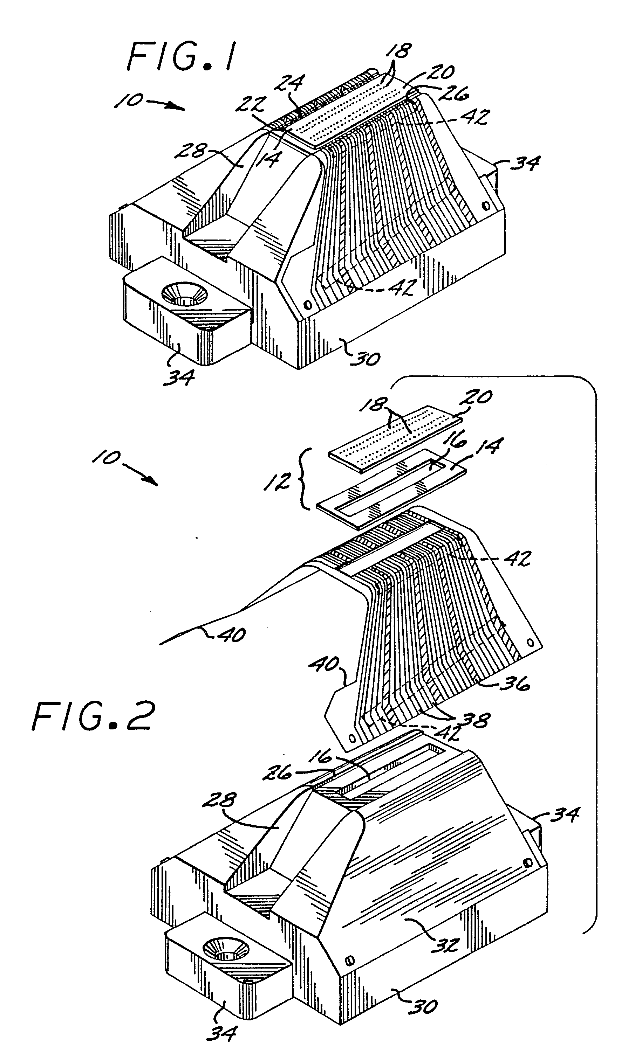

Briefly, and referring to Figures 1, 2 and 6, the printhead assembly 10 includes an ejector 12 having a silicon substrate 14 with an elongated slot 16 therein which serves as an ink intake port for providing ink to a plurality of ink reservoirs (not shown) and to corresponding ink ejection orifices 18 in an orifice plate 20 overlying the substrate 14. Ink is ejected through the orifices 18 by localized heating of the silicon substrate 14. To effect such heating, the silicon substrate 14 has a plurality of tantalum-aluminum alloy resistors (not shown), one located adjacent each orifice 18. Electrical current is provided to each resistor through a lead 22 deposited upon the silicon substrate 14, each lead 22 terminating near the edge of the substrate 14 in a bonding location 24. An electrical current delivered to a particular resistor, though the lead 22, causes the ink adjacent the resistor to be heated and vaporized, ejecting a microdroplet of ink through the orifice 18. The present invention deals with the approach for providing current to the bonding locations 22, not directly with the ejector 12 or its mode of operation. The structure and operation of ink ejectors is described more completely in the Hewlett Packard Journal, Volume 36, Number 5, May 1985, which disclosure is herein incorporated by reference.

The ejector 12 is mounted in a recess 26 in the top of a central raised portion 28 of a plastic or metal manifold 30 to place it close to the print medium, as may best be seen in the exploded view of Figure 2. The raised portion 28 has slanted side walls 32. The raised portion also has end tabs 34, which facilitate its handling and attachment to a carriage mechanism (not shown) in the printer.

Electrical current is supplied to the bonding locations 24 on the silicon substrate 14 through a flexible interconnect circuit 36, also sometimes known as a TABcircuit. The general features and structure of such flexible interconnect circuits 36, and the method of their fabrication, are described in US Patent 3,689,991. The present invention deals with a modified form of construction of the flexible interconnect circuit 36.

Generally, the flexible interconnect circuit 36 is manufactured as a flat piece and then molded to fit over the raised portion 28 and down the side walls 32 of the manifold 30. Electrical traces on the flexible interconnect circuit 36 are bonded at the end adjacent the substrate 14 to the bonding locations 24, and at the other end to external current leads (not shown). Electrical current is introduced into the respective resistors of the ejector 12 through the flexible interconnect circuit 36.

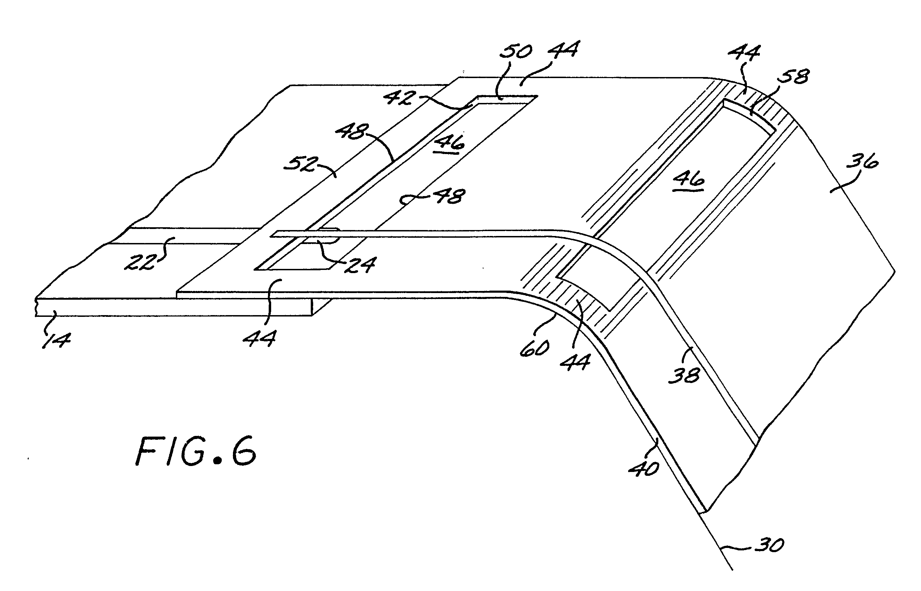

In the prior construction of the flexible interconnect circuit 36, as shown, for example, in relation to Figures 6 and 7 of US Patent 3,689,991, a thin layer of electrically conductive metal is deposited upon a continuous layer support 40 of flexible plastic such as a polyimide. The layer of conductive metal is patterned to produce individual conductive traces 38 in the proper pattern to deliver current to the intended locations. The electrical connection to the bonding locations on the substrate is provided by extending the traces in a cantilevered, unsupported fashion from the edge of the plastic support in a pattern that places them over the respective bonding locations 24 when the flexible interconnect circuit 36 is assembled to the manifold 30. (See Figure 6 of US Patent 3,689,991 and the text at col. 3, line 53-col. 4, line 4.) The cantilevered traces are welded to the bonding locations using a combination of heat and pressure, which bends the cantilevered traces downwardly to contact the bonding locations.

While this prior construction and method are operable, the construction of the flexible interconnect circuit sometimes results in a failure to achieve a proper bond. The cantilevered trace is made largely of copper. Its dimensions are typically 0.003 inches wide, 0.0007-0.0015 inches thick, and 0.020 inches long in the cantilevered portion. Adjacent traces may be separated by about 0.003 inch. The trace is therefore fragile in the sense that it may be bent easily. Even a small amount of bending may result in sufficient misalignment so that the trace misses the bonding location on the substrate when bonding is attempted, or may contact an adjacent trace. In either event, a small amount of bending of any one cantilevered trace may be sufficient to result in inoperability of the entire print head assembly. It is very difficult to effect repair, and such defective assembly is usually discarded.

Another result of the use of the cantilevered trace approach is that it is difficult to be certain of the precise location at which the electrical bond to the substrate is achieved. Common practice is therefore to raise the bonding location on the substrate or a lead to which the trace is to be bonded slightly, in a "bump", to provide a precisely defined bonding position. Providing a "bump" increases the cost and complexity of manufacturing the substrate.

Yet another result of the use of the prior approach is difficulty in bending the flexible interconnect circuit over the angular upper surface of the manifold 30. The traces are bonded to the plastic support, and bending this bonded composite material over an angular surface places stress and strain on the bonded structure. Bending is sometimes difficult, and there is a tendency to debond the trace from its support.

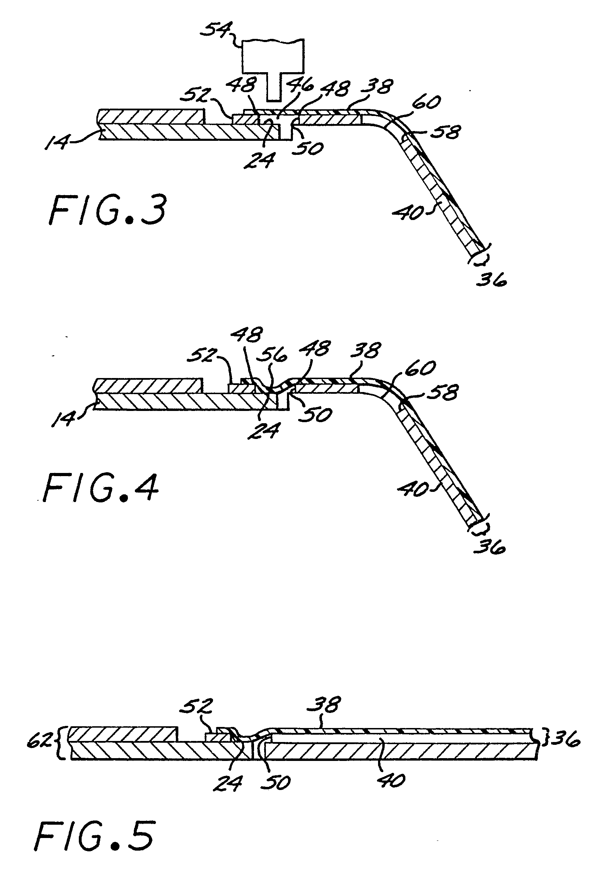

The approach of the present invention is seen generally in Figure 2, and in section in Figure 3. The flexible interconnect circuit 36 is formed of a plurality of traces 38 deposited overlying a plastic support 40. A very thin layer of adhesive is usually present between the traces 38 and the support 40, although in some interconnect circuit materials the adhesive is omitted. There are provided vias 42 through the support 40 in two forms, each of which provide particular advantages in the use of the flexible interconnect circuit material.

The vias 42 are window-like openings through the support 40. The vias do not completely sever the support material into two parts. Instead, there are end pieces 44 of support material remaining to maintain structural continuity of the support material. The vias 42 are readily etched, die cut, or stamped through the support 40 during manufacture, prior to deposition or placement of the thin sheet of conductive material which is then patterned to form the traces. Introduction of the vias 42 does not add significantly to the cost of manufacture of the flexible interconnect circuit material.

The patterning operation is conducted so that the traces 38 extend over the opening 46 of the via 42, and are supported from the edges 48 of the via 42 in at least two points. Typically, and as illustrated in Figures 2 and 3, the vias 42 are elongated with two parallel edges. The traces extend transversely over the opening 46 of the via 42, and are supported at two places, from the opposing edges 48 of the via 42. This construction is contrasted with the prior cantilevered construction, where the trace is supported from a single point.

In the first specific application of providing vias 42, a bonding via 50 is provided in that portion of the support 40 that is in register with the bonding locations 24 of the substrate 14, when the flexible interconnect circuit 36 is placed overlying the manifold 30 and substrate 14. The via construction results in a rail 52 that rests upon the substrate 14. The rail 52 provides one of the edges 48 that supports the trace 38, and the other edge 48 is provided by the main body of the support 40, on the other side of the via 42.

Figure 3 illustrates the flexible interconnect circuit 36 in place with respect to the silicon substrate 14 and the bonding location 24, but before bonding. A thermode 54 is positioned above the bonding location 24 and the corresponding registered portion of the flexible interconnect circuit 36. In the bonding operation, the thermode 54 is moved downwardly, deforming the registered portion of the trace 38 downwardly to contact the bonding location 24. The thermode 54 applies pressure and ultrasonic energy to cause the underside of the trace 38 to weld bond to the upper side of the bonding location 24. A completed bond is illustrated in Figure 4. There may be as many as several hundred such bonded joints on a typical printhead assembly 10.

The configuration of the present invention, wherein the registered portion of the trace is supported from both edges of the via 42, significantly reduces the incidence of bending or deformation of the trace prior to bonding, as contrasted with the prior approach of supporting the registered portion of the trace in a cantilevered fashion from a single point. The rail 52 portion of the support 40 provides lateral rigidity to the trace, preventing its bending either sideways or downwardly. The yield of acceptable parts produced using the flexible interconnect circuit of the present invention is therefore higher than using prior configurations of flexible interconnect circuit material, which did not have bonding vias.

Additionally, the shallow U-shaped bend that the thermode 54 introduces into the trace, as at numeral 56 of Figure 4, provides a precisely defined bonding point in conjunction with the bonding location 24. Experience has shown that it is therefore not necessary to raise the bonding location 24 in the form of a "bump" to provide a precisely defined bonding location. Without the need for the bump, the substrate is less costly to produce.

The second utilization of the via approach is for bending vias 58, also illustrated in Figures 3 and 4. The flexible interconnect circuit is conformed to the shape of the manifold 30 during fabrication, with the result that the support and the trace material must be bent to conform to angular irregularities or angularities 60 on the manifold 30. The flexible interconnect circuit material of the prior art is relatively stiff, and the bending over the angularities required a relatively high force. The bending operation placed significant stresses and strains on the support and trace materials, and the bonded interface therebetween, in some cases causing debonding and failure.

With the present approach, the bending via 50 is placed at a location in register with the angularity 60, so that at the location where the flexible interconnect support circuit 36 is bent, there is no underlying support material 40 and the stiffness of the support circuit is locally reduced. Consequently, there is less bending resistance of the support circuit, and there is no stress or strain produced resulting from the bending of two materials in contact with each other. The trace 38 is bent into the proper shape and led around the angularity 60, with the application of much less bending force than otherwise required. The trace 38 is supported on both sides of the bending via 58, and is not readily moved from its proper position.

Figure 5 illustrates the utilization of a bonding via 50 in conjunction with a flexible interconnect circuit 36 used to connect an electronic component, illustrated in the form of an integrated circuit 62. (Here, the entire structure is relatively flat, and there is no need for the use of a bending via.) The bonding via 50 is formed so that the rail 52 sits on a flat surface of the integrated circuit 62. The trace 38 is supported from the two edges 48 of the support 40, in registry with bonding locations 24 on the integrated circuit 62. Bonding is accomplished using a thermode 54, in the same manner as previously described. This use of the flexible interconnect circuit 36 offers the same advantages as found for its use in relation to the printhead assembly 10.

The flexible interconnect circuit of the invention is fabricated in a manner similar to that described in US Patent 3,689,991. A sheet of plastic support material is provided. A sheet of copper or other conductor is deposited upon the support material, either electrolytically or by a bonding operation. Traces are formed in the conductive sheet using well established lithography techniques. Regions that are not to be removed are masked, in a manner so that the regions to be removed are precisely defined and exposed. The exposed material is removed, leaving the required pattern of traces. Vias are etched through the support material, usually from the back side, or punched with a tool and die, in the locations required for a particular connector application. The locations and sizes of the vias are readily determined from the geometries of the specific application. The mask material is removed. Optionally, a gold layer is electrodeposited on the remaining conductive metal, to protect it and to enhance bonding. The flexible interconnect circuit material formed in this manner is readily produced in continuous rolls at a central location. Bonding is accomplished by bending the interconnect circuit to the proper shape (where necessary, as to fit the shape of the manifold), placing the flexible interconnect circuit in registry with the bonding locations, and accomplishing bonding using the thermode.

The present invention therefore provides important advantages in the automated production of electrical, electromechanical, and other devices where a large number of electrical connections must be made to a relatively small component. The flexible interconnect circuit of the invention increases the yields of parts of acceptable quality, by reducing the incidence of misalignment of traces and debonding.

Although particular embodiments of the invention have been described in detail for purposes of illustration, various modifications may be made without departing from the spirit and scope of the invention. Accordingly, the invention is not to be limited except as by the appended claims.

## Claims

1. An electrical connector for use in establishing electrical connection to a circuit component having at least one electrical connection point on a surface thereof, comprising:
an electrically insulating support having a via therethrough in registry with the electrical connection point of the circuit device, when the support is overlaid onto the surface of the circuit component; and
an electrically conductive trace on a surface of the support, the trace bridging across the via opening so as to be supported over the via opening by contact with the support along the edges of the via in at least two locations.

2. The connector of claim 1, wherein the electrical component includes a plurality of electrical connections with a corresponding plurality of electrical connection points, and connector includes a plurality of electrically conductive traces, each of which extends over the via opening and is supported over the via opening by contact with the support along the edges of the via in at least two locations.

3: The connector of claim 1, wherein the via includes two parallel and opposing edges, and the trace is supported from the two edges.

4. The connector of claim 1, wherein the electrically insulating support is made of plastic.

5. The connector of claim 1, wherein the trace is made of copper.

6. The connector of claim 1, wherein the trace includes a gold layer thereupon.

7. An electrical connector, comprising:
an electrically insulating support having a via therethrough; and
an electrically conductive trace on a surface of the support, the trace bridging across the via opening so as to be supported over the via opening by contact with the support along the edges of the via in at least two locations.

8. An electrically connected device, comprising:
a circuit component having at least one electrical connection point on an upper surface thereof; and
an electrical connector that provides an external electrical connection to the electrical connection point of the circuit component, the connector having
an electrically insulating support having a via therethrough in registry with the electrical connection point of the circuit component, when the support is overlaid onto the upper surface of the circuit component, and
an electrically conductive trace on a surface of the support, the trace bridging across the via opening so as to be supported over the via opening by contact with the support along the edges of the via in at least two locations.

9. The device of claim 8, wherein the circuit component is a print head assembly for a thermal ink jet printer.

10. The device of claim 8, wherein the circuit component is an integrated circuit.

11. A process for providing electrical connection for a circuit component having at least one electrical connection point on a surface thereof, comprising the steps of:
providing an electrical connector having an electrically insulating support having a via therethrough in registry with the electrical connection point of the circuit component, when the support is overlaid onto the surface of the circuit component, and
an electrically conductive trace on an upper surface of the support, the trace bridging across the via opening so as to be supported over the via opening by contact with the support along the edges of the via in at least two locations;
placing the connector to overlie the circuit component so that the via opening and a portion of the trace supported over the via opening are in registry with the electrical connection point on the surface of the circuit component; and
bonding the trace to the electrical connection point.

12. The process of claim 11, wherein the step of bonding is accomplished by ultrasonic pressure bonding.

13. The process of claim 11, wherein the step of bonding is accomplished by the application of heat and ultrasonic energy.

14. A process for conforming an electrical connector to an angular irregularity in the surface of an electrical component, comprising the steps of:
providing an electrical connector having
an electrically insulating support having a via therethrough, and
an electrically conductive trace on an upper surface of the support, the trace bridging across the via opening so as to be supported over the via opening by contact with the support along the edges of the via in at least two locations;
placing the connector to overlie the circuit component so that the via opening and a portion of the trace are supported over the angular irregularity; and
bending the electrical connector so that the traces are bent over the angular irregularity in the region overlying the via opening, whereby the traces are not in contact with support material in the region in which they are bent.

FIG.1

FIG.2

FIG.3

FIG.4

FIG.5

FIG.6

EP 0 366 405 A2